# FASCICULE DE BREVET EUROPEEN

(11) **EP 3 229 036 B1**
(45) Date de publication et mention de la délivrance du brevet: **26.12.2018**
(21) Numéro de dépôt: 17164946.0
(22) Date de dépôt: 05.04.2017
(51) Int. Cl.: H01F 10/14, H01F 10/16, H01F 10/30, H01F 10/00, H01F 13/00, G01R 33/00, G01R 33/038

(54) **AIMANT PERMANENT COMPRENANT UN EMPILEMENT DE N MOTIFS**
DAUERMAGNET, DER EINEN STAPEL MIT N MOTIVEN UMFASST
PERMANENT MAGNET COMPRISING A STACK OF N PATTERNS

(30) Priorité: 06.04.2016 FR 1653013
(43) Date de publication de la demande: 11.10.2017
(73) Titulaire: COMMISSARIAT À L'ÉNERGIE ATOMIQUE ET AUX ÉNERGIES ALTERNATIVES, 75015 Paris (FR)
(72) Inventeur: DELAET, Bertrand, 38190 BERNIN (FR); GIROUD, Sophie, 38120 SAINT-EGREVE (FR); HIDA, Rachid, 38210 CRAS (FR)
(74) Mandataire: Colombo, Michel

(56) Documents cités:
- WO-A1-2015/166159
- DE-A1-102007 032 299

## Description

L'invention concerne un aimant permanent ainsi qu'un capteur de champ magnétique incorporant cet aimant permanent. L'invention concerne également un procédé de fabrication de cet aimant permanent.

Des capteurs connus de champ magnétique incorporent des aimants permanents pour mesurer l'amplitude, dans une direction donnée, d'un champ magnétique à mesurer. De tels capteurs sont décrits, par exemple, en référence à la figure 4 de la demande US2011/0151589 ou en référence aux figures 1A à 8 de la demande WO2010/0084165. D'autres capteurs sont décrits dans les demandes WO2015/166159A1 et DE102007032299A1.

Les aimants permanents utilisés dans ces capteurs, contrairement aux couches piégées (« pinned layer » en anglais) utilisées dans les vannes de spin ou GMR (« Giant Magnetoresistance ») et dans les jonctions tunnels ou TMR (« Tunnel Magnetoresistance »), doivent générer un champ magnétique important. Pour rappel, dans les vannes de spin et les jonctions tunnels, le champ magnétique généré par la couche piégée doit au contraire être faible pour permettre à la direction d'aimantation de la couche libre de tourner et de s'aligner sur la direction d'un champ magnétique extérieur. Ainsi dans le cas de structures dynamiques, comme des structures MRAM (Magnetoresistive Random Access Memory) par exemple, l'aimantation évolue lors de l'utilisation de la structure. Au contraire, dans les aimants permanents, la direction d'aimantation est figée.

Pour obtenir un champ magnétique important, dans les capteurs connus, l'aimant permanent est réalisé par un empilement de couches ferromagnétiques et de couches antiferromagnétiques. Typiquement, un tel aimant permanent comporte un empilement de N motifs empilés immédiatement les uns sur les autres dans une direction d'empilement, où N est un nombre entier supérieur ou égal à deux, chaque motif comportant :
- une couche antiferromagnétique réalisée en matériau antiferromagnétique,
- une couche ferromagnétique réalisée en matériau ferromagnétique, la direction d'aimantation de la couche ferromagnétique étant figée par un couplage d'échange avec la couche antiferromagnétique de ce motif, et la direction d'aimantation de la couche ferromagnétique de N-1 motifs étant également figée par un couplage d'échange avec la couche antiferromagnétique d'un motif immédiatement adjacent dans l'empilement, les directions d'aimantation des différentes couches ferromagnétiques de tous les motifs étant toutes identiques les unes aux autres.

Dans les aimants permanents connus chaque couche ferromagnétique est coincée entre deux couches antiferromagnétiques. De tels modes de réalisation d'un aimant permanent sont décrits en référence à la figure 1A de la demande US 2011/0151589 et en référence aux figures 10A et 10B de la demande WO 2010/0084165.

Dans cette description, lorsqu'on indique qu'une couche ou une sous-couche est « réalisé en X » ou lorsqu'on parle d'une « couche X » ou d'une « couche de X » ou d'une « couche en X », on désigne une couche ou une sous-couche dans laquelle le matériau X représente plus de 95 % de sa masse, et généralement, plus de 98 % ou 99 % de sa masse.

Par couches ferromagnétiques et antiferromagnétiques, on désigne des couches réalisées, respectivement, en matériau ferromagnétique et en matériau antiferromagnétique.

Par la suite, le champ magnétique d'un aimant permanent comportant un empilement de couches ferromagnétiques et antiferromagnétiques est considéré comme important si le moment magnétique total de cet aimant par unité de surface est supérieur à 50 x 10⁻³ A et, de préférence, supérieur à 500 x 10⁻³ A ou 1000 x 10⁻³ A.

Le moment magnétique par unité de surface d'un aimant permanent comportant un empilement de couches ferromagnétiques et antiferromagnétique peut facilement être mesuré. Par exemple, le moment magnétique de l'aimant permanent est mesuré par la méthode VSM (« Vibrating Sample Magnetometry »). Cette méthode est bien connue. Elle est par exemple décrite dans les articles suivants :
- Simon FONER, « Versatile and Sensitive Vibrating-Sample Magnetometer », The review of scientific instrucments, Volume 30, number 7, juillet 1959,
- Christian Albrechts, « Vibrating Sample Magnetometry », Université de Kiel, M106, 2011.

Le moment magnétique ainsi mesuré est alors divisé par le volume de matériau ferromagnétique contenu dans cet aimant pour obtenir son aimantation. Quel que soit l'empilement, les dimensions des couches ferromagnétiques peuvent être facilement mesurées, par exemple, par observation de coupes verticales de cet empilement avec un microscope. En particulier, ces observations permettent de mesurer l'épaisseur tᵢ de chaque couche ferromagnétique. Enfin, l'aimantation ainsi obtenue est multipliée par la somme des épaisseurs tᵢ de chaque couche ferromagnétique pour obtenir le moment magnétique de cet aimant par unité de surface. Généralement, les couches ferromagnétiques de l'empilement ont toutes la même surface dans un plan perpendiculaire à la direction d'empilement de ces couches. Par conséquent, on peut aussi diviser le moment magnétique mesuré pour l'aimant par la surface des couches ferromagnétiques, ou par la surface de l'aimant permanent si elle est égale à la surface des couches ferromagnétiques, pour obtenir le moment magnétique par unité de surface.

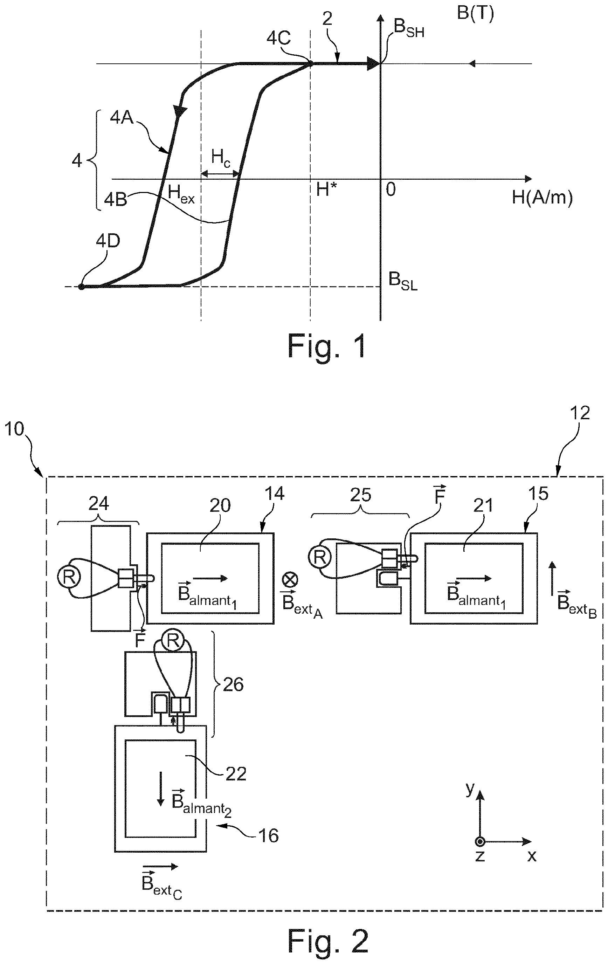

L'aimantation d'un tel aimant permanent, présente typiquement un cycle d'hystérésis tel que celui représenté sur la figure 1.

La figure 1 va maintenant être utilisée pour définir certains termes. La courbe 2 représente de façon schématique l'évolution de l'aimantation, notée B sur les figures, de l'aimant permanent en fonction du champ magnétique H. Plus précisément, l'aimantation B varie entre deux valeurs extrêmes BSL et B_{SH}. Lorsque l'aimantation de l'aimant permanent approche la valeur BSH, son aimantation n'augmente plus significativement même si le champ magnétique H augmente. Pour simplifier la figure 1, cette augmentation non significative de l'aimantation B en fonction du champ H a été représenté par une ligne horizontale. On dit alors que l'aimant est saturé. Le même phénomène se produit lorsque l'aimantation approche la valeur B_{SL} et que le champ magnétique continue à diminuer. Entre ces deux valeurs extrêmes, la courbe 2 définit un cycle 4 d'hystérésis. Le cycle 4 comporte :
- une courbe 4A qui descend au fur et à mesure que le champ magnétique H diminue, et
- une courbe 4B qui monte au fur et à mesure que le champ magnétique H augmente.

Les courbes 4A et 4B se rejoignent d'un côté au voisinage d'un point 4C et de l'autre côté au voisinage d'un point 4D. Entre ces points 4C et 4D, les courbes 4A et 4B sont distinctes. Au-delà du point 4C et en-deçà du point 4D, les courbes 4A et 4B sont sensiblement confondues et pour des champs importants en valeur absolue on tend vers la saturation. Ici, le point 4C est le plus proche de l'axe des ordonnées.

Au niveau des points 4C et 4D, l'écart entre les courbes 4A et 4B est égal à 2 % de la valeur B_{R}, B_{R} correspondant à l'aimantation à champ nul (c'est-à-dire pour le champ H=0).

Dans le cas des aimants permanents formés par l'empilement de couches ferromagnétiques et antiferromagnétiques, le cycle 4 d'hystérésis est, généralement, décalé, par exemple comme représenté sur la figure 1. Plus précisément, le cycle 4 est décalé, par rapport à l'axe des ordonnées, d'une valeur Hₑₓ appelée par la suite champ d'échange Hₑₓ ou champ Hₑₓ. Ce champ Hₑₓ est également connu sous le terme anglais de « exchange bias ». Typiquement, la valeur du champ Hₑₓ correspond à la valeur de l'abscisse du point situé à mi-distance entre les deux points où le cycle 4 coupe l'axe des abscisses. Dans ce graphe, l'axe des abscisses représente le champ magnétique H.

Le champ coercitif H_{c} ou champ H_{c} de l'aimant permanent est la demi-largeur du cycle 4. Typiquement, sa valeur est prise égale à la différence entre la valeur du champ Hₑₓ et un point d'intersection du cycle 4 avec l'axe des abscisses.

On définit également le champ H* comme étant le plus petit champ magnétique à partir duquel l'hystérésis de l'aimant permanent disparaît, c'est-à-dire comme précisé ci-dessus, le champ magnétique pour lequel l'hystérésis est inférieure à 2% de la valeur B_{R}. Ici, la valeur du champ H* est égale à la valeur de l'abscisse du point 4C.

Il est souhaitable que l'aimant présente un champ H* aussi éloigné que possible de l'axe des ordonnées. En effet, cela améliore l'insensibilité de cet aimant aux perturbations magnétiques extérieures. Cela permet aussi d'améliorer la dynamique des capteurs de champ magnétique qui incorporent de tels aimants.

L'invention vise à satisfaire ce souhait. A cet effet, l'invention a pour objet un aimant permanent conforme à la revendication 1.

Les modes de réalisation de cet aimant permanent peuvent comporter une ou plusieurs des caractéristiques des revendications dépendantes.

Ces modes de réalisation de l'aimant permanent présentent en outre les avantages suivants :
- Le fait que la sous-couche en CoFeB soit éloignée d'au moins 5 nm de l'interface entre la couche ferromagnétique et la couche antiferromagnétique du motif suivant facilite le dépôt de cette couche antiferromagnétique.
- Réaliser l'aimant permanent avec un facteur de forme supérieur ou égale à deux permet de faciliter l'alignement de la direction d'aimantation de chaque couche ferromagnétique sur la direction longitudinale de l'aimant permanent lors de sa fabrication.

L'invention a également pour objet un capteur de champ magnétique et un procédé de fabrication de l'aimant permanent revendiqué.

L'invention sera mieux comprise à la lecture de la description qui va suivre, donnée uniquement à titre d'exemple non limitatif tout en se référant aux dessins sur lesquels :
- la figure 1 est une illustration schématique du cycle d'hystérésis d'un aimant permanent réalisé à partir d'un empilement de couches ferromagnétiques et antiferromagnétiques ;
- la figure 2 est une illustration schématique, en vue de dessus, d'un capteur de champ magnétique ;
- la figure 3 est une illustration schématique, en coupe verticale longitudinale, d'un aimant permanent du capteur de la figure 2 ;
- la figure 4 est un organigramme d'un procédé de fabrication de l'aimant permanent de la figure 3 ;
- la figure 5 est une illustration schématique, en coupe verticale longitudinale, d'un autre mode de réalisation possible pour des motifs de l'aimant permanent de la figure 3.

Dans ces figures, les mêmes références sont utilisées pour désigner les mêmes éléments. Dans la suite de cette description, les caractéristiques et fonctions bien connues de l'homme du métier ne sont pas décrites en détail.

La figure 2 représente un capteur 10 de champ magnétique. Ce capteur 10 est identique au capteur décrit en référence à la figure 8 de la demande WO2010/084165, sauf en ce qui concerne la structure des aimants permanents utilisés. Ainsi, seule une brève description de l'architecture générale de ce capteur est donnée pour illustrer un exemple de réalisation d'un tel capteur.

Ce capteur 10 comprend :
- un substrat 12 s'étendant essentiellement dans un plan horizontal parallèle à des directions orthogonales X et Y, et
- trois magnétomètres 14 à 16 mono-axes réalisés sur le substrat 12.

Une direction Z, perpendiculaire aux directions X et Y, représente la verticale. Par la suite, les figures suivantes sont orientées par rapport à ce même repère X, Y, Z. De plus, les termes tels que « au-dessus », « en dessous », « en bas », « en haut » sont définis par rapport à cette direction Z.

Les magnétomètres 14 à 16 mesurent l'amplitude du champ magnétique à mesurer dans les directions, respectivement, Z, Y et X. A cet effet, chaque magnétomètre 14 à 16 comporte :
- un aimant permanent, respectivement 20 à 22, apte à se déplacer par rapport au substrat 12, et
- un transducteur, respectivement 24 à 26, apte à transformer le déplacement de l'aimant permanent en une variation de courant ou de tension correspondante.

Par exemple, les transducteurs 24 à 26 sont des transducteurs piézorésistifs. Typiquement, ces transducteurs sont fixés, sans degré de liberté, d'un côté sur le substrat 12 et, d'un autre côté, à l'aimant permanent.

Ici, les aimants permanents 20 à 22 sont identiques à l'exception du fait que la direction du moment magnétique globale de l'aimant permanent 22 est perpendiculaire à celle des aimants permanents 20 et 21. Dès lors, seule une description détaillée de l'aimant permanent 20 est donnée par la suite.

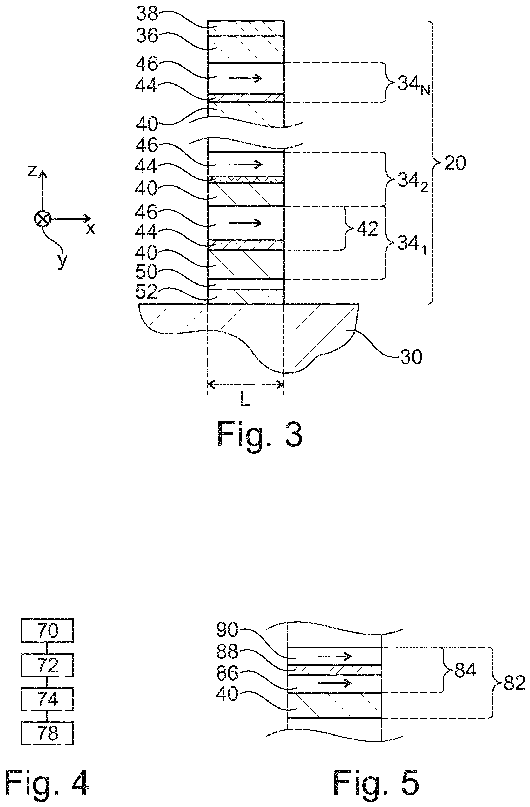

La figure 3 représente l'aimant permanent 20 déposé sur un socle 30 mobile par rapport au substrat 12. Par exemple, le socle 30 est obtenu par gravure du substrat 12. Seule une portion de ce socle 30 est représentée sur la figure 3.

L'aimant 20 est formé d'un empilement, dans une direction d'empilement, de couches ferromagnétiques et antiferromagnétiques. Ici, la direction d'empilement est parallèle à la direction Z. Sur la figure 3 et les suivantes, les conventions suivantes sont adoptées :
- les couches antiferromagnétiques sont hachurées,
- la direction du moment magnétique d'une couche ferromagnétique est représentée par une flèche,
- les lignes ondulées au milieu de l'empilement indiquent qu'une portion intermédiaire de cet empilement n'a pas été représentée,
- les proportions entre les épaisseurs des différentes couches ne sont pas respectées pour améliorer la lisibilité des figures, et
- la proportion entre la longueur L et la hauteur de l'empilement n'est pas respectée pour réduire la taille des figures dans la direction longitudinale de l'empilement.

Ici, l'empilement présente une forme parallélépipédique et un facteur de forme supérieur ou égal à 2, 5 ou 20, voire même supérieur à 100 ou 1000. Dans ce mode de réalisation, le facteur de forme est défini comme étant le rapport de la longueur L sur la largeur W de l'empilement. Ici, la longueur est parallèle à la direction X et la largeur W est parallèle à la direction Y.

Plus le facteur de forme est important et plus il est facile d'aligner la direction d'aimantation des couches ferromagnétiques sur la direction longitudinale de l'empilement. Par exemple, la largeur de l'empilement est inférieure à 20 µm ou 10 µm et la longueur L est supérieure à 50 µm ou 100 µm ou 1 mm. La hauteur de l'empilement est généralement supérieure à 100 µm ou 500 µm. Cette hauteur est mesurée entre la couche de l'empilement la plus proche du socle 30 et la couche de ce même empilement la plus éloignée du socle 30.

Ici, l'empilement de couches ferromagnétiques et antiferromagnétiques est composé successivement dans la direction Z :
- d'un motif 34 répété N fois, puis
- d'une couche antiferromagnétique 36 puis, typiquement,
- d'une couche 38 d'encapsulation déposée au sommet de cet empilement.

La couche 38 est destinée à protéger l'aimant permanent des agressions chimiques et/ou physiques de l'environnement extérieur. Cette couche 38 est réalisée dans un matériau non magnétique. Par matériau non magnétique, on désigne ici un matériau dépourvu de propriété magnétique susceptible de perturber le fonctionnement de l'aimant permanent 20. Généralement, il s'agit d'un matériau dont les propriétés magnétiques sont nulles ou non mesurables.

Typiquement, la couche 38 est réalisée en Tantale (Ta) ou en Molybdène (Mo) ou en Ruthénium (Ru) ou une combinaison de ces matériaux. Par exemple, la couche 38 est réalisée en tantale (Ta) et son épaisseur est supérieure ou égale à 10 nm.

La couche 36 est une couche antiferromagnétique. Elle est par exemple identique à la couche 40 décrite plus loin.

Dans ce mode de réalisation, la direction d'empilement des motifs 34 est parallèle et de même sens que la direction Z. La première occurrence du motif 34 dans l'empilement, c'est-à-dire celle qui est la plus proche du socle 30 porte la référence 34₁, la seconde occurrence immédiatement au-dessus de cette première occurrence 34₁ porte la référence 34₂ et ainsi de suite jusqu'à l'occurrence 34_{N}.

Ici, les occurrences 34₁ à 34_{N} sont directement empilées les unes au-dessus des autres et ne sont donc séparées les unes des autres par aucune autre couche n'appartenant pas au motif 34.

Le nombre N de répétitions du motif 34 est généralement choisi pour atteindre une hauteur souhaitée de l'empilement. Cette hauteur dépend de l'application envisagée. N est supérieur ou égal à 2 et, de préférence, supérieur à 5 ou 10 ou 20. N est également généralement inférieur à 50 ou 100. Ici, N est également choisi de manière à atteindre le moment magnétique par unité de surface recherché pour l'aimant permanent.

Dans ce mode de réalisation, les différentes occurrences du motif 34 sont toutes identiques les unes aux autres et seule l'occurrence 34₁ va donc être décrite en détail.

L'occurrence 34₁ est composée successivement dans la direction Z :
- d'une couche antiferromagnétique 40, et
- d'une couche ferromagnétique 42 dont la direction d'aimantation est piégée par couplage d'échange avec la couche antiferromagnétique 40.

Dans cette demande, par couche « antiferromagnétique » on désigne une couche horizontale d'épaisseur constante dans laquelle le ou les matériaux antiferromagnétiques représentent plus de 95 % ou 98 % ou 99 % de la masse de cette couche.

Dans cette description, les matériaux antiferromagnétiques utilisés sont par exemple choisis dans le groupe composé :
- des alliages de manganèse, et
- du NiO, et
- du Fe₂O₃.

Les alliages de manganèse antiferromagnétiques sont typiquement le PtMn, NiMn, PdPtMn, FeMn et IrMn. Dans cet exemple, le matériau antiferromagnétique choisi pour la couche 40 est l'alliage IrMn.

Dans cette demande, par couche « ferromagnétique » on désigne une couche horizontale d'épaisseur constante dans laquelle le ou les matériaux ferromagnétiques représentent plus de 95 % ou 98 % ou 99 % de la masse de cette couche.

Les matériaux ferromagnétiques utilisés sont par exemple choisis dans le groupe composé :
- des alliages à base de Fe et/ou Co et/ou Ni, comme par exemple CoFe, NiFe, CoFeSi..., et
- des alliages d'Heusler comme par exemple Cu2MnSn ou Co₂MnSi ou Ni₂MnAl....

Dans ce mode de réalisation, la direction d'aimantation c'est-à-dire la direction du moment magnétique, de la couche 42 est parallèle et de même sens que la direction X. Typiquement, l'amplitude de l'aimantation à saturation de la couche 42 est supérieure ou égale à 397887 A/m ou 795774 A/m ou 1432394 A/m.

Cette direction d'aimantation est piégée par un couplage d'échange avec la couche 40. Un couplage d'échange entre une couche ferromagnétique et une couche antiferromagnétique apparaît si :
- la couche ferromagnétique est directement déposée sur la couche antiferromagnétique, ou
- uniquement séparée de la couche antiferromagnétique par une (ou plusieurs) très fine(s) couche(s) non-magnétique(s) dont l'épaisseur totale est inférieure à 0,5 nm et, de préférence, inférieure à 0,4 nm ou 0,2 nm.

Le couplage d'échange entre les couches ferromagnétique et antiferromagnétique est bien connu. Par exemple, le lecteur peut se référer à l'article suivant : J. Nogués et Ivan K. Schuller, « Exchange bias » Journal of magnetism and magnetic materials 192 (1999), 203-232.

La présence du couplage d'échange entre la couche ferromagnétique et la couche antiferromagnétique se traduit notamment par un décalage, par exemple, vers la gauche comme illustré sur la figure 1, du cycle d'hystérésis de l'assemblage de ces deux couches et donc par l'apparition d'un champ Hₑₓ non nul.

Ici, l'épaisseur des couches 40 et 42 sont choisies pour obtenir un bon couplage d'échange entre ces deux couches. Dans cette description, on considère que le couplage d'échange est bon si cela se traduit par l'apparition d'un champ d'échange Hₑₓ dont la valeur absolue est supérieure à 50 Oe (3978 A/m) et, de préférence, supérieure à 100 Oe (7957 A/m) ou 200 Oe (15915 A/m) ou 500 Oe (39788 A/m) à 25°C.

Les champs Hₑₓ et H_{c} d'un empilement comportant seulement les couches 40 et 42 peut être mesuré expérimentalement ou obtenu par simulation numérique.

Un bon couplage d'échange permet en cas de perturbation magnétique extérieure importante de revenir à l'état initial après la disparition de cette perturbation.

L'épaisseur des couches 40 et 42 est, par exemple, déterminée par expérimentation ou par simulation numérique en testant successivement des épaisseurs différentes pour un empilement formé seulement d'une couche antiferromagnétique et d'une couche ferromagnétique réalisées dans les mêmes matériaux que les couches 40 et 42. Pour les matériaux antiferromagnétiques et ferromagnétiques les plus courants, les épaisseurs appropriées sont connues de l'homme du métier. Par exemple, typiquement, l'épaisseur de la couche 40 est comprise entre 5 et 100 nm et, de préférence, entre 5 et 25 nm. L'épaisseur de la couche 42 est souvent comprise entre 0,5 nm et 100 nm. Dans cet exemple, l'épaisseur de la couche 40 est de préférence comprise entre e_{FM}/3 et 3e_{FM} pour obtenir un bon couplage d'échange, où e_{FM} est l'épaisseur de la couche 42. Ici, l'épaisseur de la couche 40 est de 7 nm tandis que l'épaisseur de la couche 42 est de 20 nm.

Le moment magnétique global de l'aimant permanent 20 est proportionnel à la somme des moments magnétiques des couches 42 de l'empilement.

Pour éloigner le champ H* de l'axe des ordonnées, la couche 42 comporte une sous-couche 44 de CoFeB, et une sous-couche 46 réalisée dans un matériau ferromagnétique différent du CoFeB.

Dans cette description, la composition d'une couche ou d'une sous-couche est notée de la façon suivante : AₓB_{y}, où :
- A et B sont les symboles des éléments chimiques composant cette couche ou sous-couche, et
- l'indice x est la masse de l'élément A dans la couche ou sous-couche exprimé en pourcentage de la masse de cette couche ou sous-couche, et
- l'indice y est la masse de l'élément B dans la couche ou sous-couche exprimé en pourcentage de la masse de cette couche ou sous-couche.

Ici, la composition de la sous-couche 44 est notée CoₓFe_{y}B_{z}. De préférence, la composition de la sous-couche 44 est telle que z est compris entre 10 % et 30 % en masse atomique. Avantageusement on choisira également x et y supérieurs ou égaux chacun à 10%.

Par exemple, la composition de la sous-couche 44 est la suivante : Co₂₈Fe₅₂B₂₀ ou Co₄₀Fe₄₀B₂₀ ou Co₄₃Fe₄₃B₁₄.

L'épaisseur de la sous-couche 44 est supérieure à 0,05 nm ou 0,1 nm et, de préférence, supérieure à 0,5 nm. De préférence, l'épaisseur maximale de la sous-couche 44 est inférieure à 10 nm et, avantageusement, inférieure à 5 nm ou 2 nm.

Dans ce mode de réalisation, la sous-couche 44 est située au plus proche de la couche 40. Dans ce cas, on dit que la sous-couche 44 est située à l'interface entre les couches 40 et 42 du motif 34. Ici la sous-couche 44 est directement déposée sur la couche 40.

La sous-couche 46 est, par exemple, réalisée dans un matériau ferromagnétique choisi dans le groupe composé du cobalt, du nickel, du fer et de leurs alliages. Par exemple, le matériau ferromagnétique est souvent du CoFe ou NiFe. Ici, la sous-couche 46 est réalisée en CoFe. La composition de la sous-couche 46 est notée CoₐFe_{b}. Les pourcentages a, b de Cobalt et de Fer dans la sous-couche 46 sont différents des pourcentages x, y de ces mêmes éléments dans sous-couche 44. Par exemple, la sous-couche 46 est réalisée en Co₃₅Fe₆₅ ou en Co₈₀Fe₂₀.

L'épaisseur e₄₆ de la sous-couche 46 est strictement supérieure à l'épaisseur e₄₄ de la sous-couche 44. Typiquement, l'épaisseur e₄₆ est au moins deux ou cinq ou dix ou vingt fois supérieure à l'épaisseur e₄₄.

Dans le mode de réalisation illustré sur la figure 3, le premier motif 34₁ est directement déposé sur une couche 50 de germination ou « seed layer » en anglais. La couche 50 peut être, par exemple, une couche en matériau non-magnétique utilisée pour faciliter le dépôt, par exemple par croissance par épitaxie, de la couche 40. La couche 50 est par exemple une couche de Ruthénium de 3 nm d'épaisseur. Ici, la couche 50 est elle-même directement déposée sur une couche d'accroché 52 ou « Buffer layer » en anglais. La couche 52 est par exemple une couche de Tantale de 5 nm d'épaisseur. La couche 52 est directement déposée sur le socle 30. D'autres variantes sont bien sûr possibles et notamment une unique couche servant à la fois de seed layer et de Buffer layer.

La figure 4 représente un procédé de fabrication de l'aimant permanent 20. Plus précisément, lors d'une étape 70, les différentes couches décrites en référence à la figure 3 sont déposées les unes sur les autres. Pour cela, on utilise des méthodes connues dans le domaine des microtechnologies et de la réalisation des puces électroniques. Lors de l'étape 70, aucune mise en forme particulière n'est donnée à cet empilement de couches. Cet empilement recouvre au moins les emplacements où doivent être réalisés les aimants 20 à 22.

Lors d'une étape 72, cet empilement est structuré pour ne laisser subsister que des empilements en forme de barreau aux emplacements où les aimants 20 à 22 doivent être réalisés. Ainsi, à l'issue de cette étape, il ne subsiste que des barreaux ayant les facteurs de forme requis, c'est-à-dire généralement supérieur à 2, 10 ou 100.

Ensuite, lors d'une étape 74, les barreaux sont chauffés pour que la température des couches antiferromagnétiques dépasse leur température de mise en ordre. Ce recuit est effectué sous champ magnétique saturant comme décrit par exemple dans la demande US 2011/0151589.

Ensuite comme décrit par exemple dans la demande US 2011/0151589, lors d'une étape 78, les barreaux sont refroidis sous un champ plus faible jusqu'à ce que les couplages d'échange entre les couches ferromagnétiques et antiferromagnétiques apparaissent et piègent les directions d'aimantation de chaque couche ferromagnétique. On obtient alors les aimants permanents 20 à 22.

Pour les autres étapes de fabrication du capteur 10, le lecteur peut se référer aux demandes de brevet précédemment citées dans l'introduction.

Différents expériences ont été réalisées pour montrer l'intérêt d'introduire la sous-couche 44 au sein de la couche ferromagnétique 42. Le tableau ci-dessous résume les résultats expérimentaux obtenus.

| N° aimant | B_{R} (nWb) | Hₑₓ (Oe) | H_{c} (Oe) | Hₑₓ/H_{c} | Hₑₓ-H_{c} | « squareness » | H* (Oe) |
|---|---|---|---|---|---|---|---|
| 1 | 22,52 | 156,7 | 34,21 | 4,58 | 122,49 | 0,9524 | 94,9 |
| 2 | 22,48 | 145,9 | 50,62 | 2,88 | 95,28 | 0,945 | 78 |
| 3 | 18,81 | 160,4 | 22,56 | 7,10 | 137,84 | 0,975 | 108,7 |
| 4 | 17,77 | 149,2 | 24,46 | 6,09 | 124,74 | 0,964 | 91,4 |
| 5 | 17,69 | 211 | 43,17 | 4,88 | 167,83 | 0,934 | 127 |
| 6 | 17,38 | 202,9 | 65,74 | 3,08 | 137,16 | 0,932 | 107 |

Dans le tableau ci-dessus, la première colonne comporte le numéro de l'aimant sur lequel les mesures ont été réalisées. Ici, chaque aimant a été réalisé en mettant en oeuvre le procédé de la figure 4 à l'exception de l'étape 72. Ainsi, les aimants testés ne sont pas structurés et ne s'allongent donc pas dans une direction particulière. Pour simplifier les mesures expérimentales, chaque aimant permanent comporte seulement deux motifs 34.

Ci-dessous, pour chaque numéro d'aimant, on donne la composition de chaque couche/sous-couche en partant de la couche 52 et en allant jusqu'à la couche 38. Dans les lignes ci-dessous, la composition d'une couche est séparée de la composition des couches immédiatement précédente et suivante dans l'empilement par le symbole « / ». Le chiffre, qui est séparé de la composition de la couche par un espace, exprime l'épaisseur de cette couche en nanomètre.
Aimant N°1: Ta 5/ Ru 3/ Ir₂₀Mn₈₀ 10/ Co₄₃Fe₄₃B₁₄ 1/ Fe₆₅Co₃₅ 19/ Ir₂₀Mn₈₀ 10/ Co₄₃Fe₄₃B₁₄ 1/ Fe₆₅Co₃₅ 19/ Ir₂₀Mn₈₀ 10/ Ta 10.
Aimant N°2 : Ta 5/ Ru 3/ Ir₂₀Mn₈₀ 10/ Fe₆₅Co₃₅ 20/ Ir₂₀Mn₈₀ 10/ Fe₆₅Co₃₅ 20/ Ir₂₀Mn₈₀ 10/ Ta 10.
Aimant N°3: Ta 5/ Ru 3/ Ir₂₀Mn₈₀ 10/ Co₄₃Fe₄₃B₁₄ 1/ Co₈₀Fe₂₀ 19/ Ir₂₀Mn₈₀ 10/ Co₄₃Fe₄₃B₁₄ 1/ Fe₆₅Co₃₅ 19/ Ir₂₀Mn₈₀ 10/ Ta 10.
Aimant N°4 : Ta 5/ Ru 3/ Ir₂₀Mn₈₀ 10/ Fe₆₅Co₃₅ 20/ Ir₂₀Mn₈₀ 10/ Co₈₀ Fe₂₀ 20/ Ir₂₀Mn₈₀ 10/ Ta 10.
Aimant N°5: Ta 5/ Ru 3/ Ir₂₀Mn₈₀ 7/ Co₄₃Fe₄₃B₁₄ 0,5/ Fe₆₅Co₃₅ 15/ Ir₂₀Mn₈₀ 7/ Co₄₃Fe₄₃B₁₄ 0,5/ Fe₆₅Co₃₅ 15/ Ir₂₀Mn₈₀ 7/ Ta 10.
Aimant N°6: Ta 5/ Ru 3/ Ir₂₀Mn₈₀ 7/ Fe₆₅Co₃₅ 15/ Ir₂₀Mn₈₀ 7/ Fe₆₅Co₃₅ 15/ Ir₂₀Mn₈₀ 7/ Ta 10.

Le champ B_{R} du tableau correspond au flux magnétique mesuré en champ nul. Il est exprimé en nano-Weber (nWb). On rappelle que 1 Wb = 1 T·m². Les champs Hₑₓ, H_{c} et H* du tableau sont exprimés en Oersted (Oe). On rappelle que 1 Oe = 1000/(4π) A.m⁻¹. On rappelle également que H* correspond au champ magnétique pour lequel l'hystérésis est inférieure à 2% de la valeur de B_{R}. La colonne « Squareness » contient une valeur qui est d'autant plus élevé que le cycle d'hystérésis de l'aimant est proche d'un rectangle. Cette valeur est calculée à l'aide de la formule suivante : Squareness = (1 - (B_{R} / (SlopeAtH_{c} * H_{c}))), où SlopeAtH_{c} est la pente de la courbe de l'aimantation B en fonction du champ H au niveau du point d'abscisse Hₑₓ - H_{c}.

Les différentes mesures indiquées dans le tableau ont été obtenues à l'aide d'un appareil de mesure connu sous le terme de « BH-Looper ». Ici, il s'agit de l'appareil MESA-200 commercialisé par la société SHB instruments.

Comme le montre les mesurent indiquées dans le tableau, à quantité de matériaux ferromagnétique et antiferromagnétique identique, l'introduction de la sous-couche 44 dans la couche ferromagnétique 42 permet d'éloigner le champ H* de l'axe des ordonnées par rapport à un aimant identique mais dépourvu de la sous-couche 44. De plus, la présence de la sous-couche 44 permet aussi d'accroître le ratio Hₑₓ/H_{c}. Ainsi, l'aimant permanent 20 présente une insensibilité accrue aux perturbations magnétiques extérieures car le champ H* s'éloigne de l'axe des ordonnées, ce qui améliore la dynamique du capteur incorporant cet aimant permanent car le cycle d'hystérésis de l'aimant est plus carré.

Enfin, augmenter le ratio Hₑₓ/H_{c} est également utile pour fabriquer l'aimant 20 avec la forme d'un barreau longiligne. En effet, il est connu que la mise en forme de l'aimant permanent sous la forme d'un barreau longiligne ayant un facteur de forme important augmente la valeur du champ H_{c} alors que le champ Hₑₓ reste constant. Ainsi, si avant une mise en forme le ratio Hₑₓ/H_{c} n'est pas assez important, après mise en forme, le champ H* est très proche de zéro ou supérieur à zéro de sorte que ce barreau aimanté est alors très sensible aux perturbations magnétiques extérieures.

La figure 5 représente un motif 82 apte à remplacer le motif 34 dans l'aimant 20. Le motif 82 est identique au motif 34 sauf que la couche ferromagnétique 42 est remplacée par une couche ferromagnétique 84. La couche 84 est identique à la couche 42 sauf qu'elle est réalisée par l'empilement l'une sur l'autre de trois sous-couches. Plus précisément, elle comporte, directement empilées les unes sur les autres dans la direction Z :
- une sous-couche ferromagnétique 86,
- une sous-couche 88 en CoFeB, et
- une sous-couche ferromagnétique 90.

Les sous-couches ferromagnétiques 86, 90 sont réalisées dans un matériau ferromagnétique différent du CoFeB. Par exemple, elles sont réalisées dans le même matériau ferromagnétique que celui décrit pour la sous-couche 46. Ici, l'épaisseur de la sous-couche 90 est de préférence supérieure à 5 nm pour isoler la sous-couche 88 de l'interface entre la couche 84 et la couche antiferromagnétique déposée sur cette couche 84. Cela facilite la fabrication de l'empilement des motifs 82.

A part sa position au sein de la couche 84, la sous-couche 88 est par exemple identique à la sous-couche 44.

De nombreux autres modes de réalisation sont possibles. Par exemple, la couche ferromagnétique peut comporter plusieurs sous-couches 44, 88. Par exemple, la couche ferromagnétique comporte deux ou trois ou quatre exemplaires de la sous-couche 44 ou 88 disposés à l'intérieur de la même couche ferromagnétique. Chaque exemplaire de la sous-couche 44 ou 88 est alors séparé de l'exemplaire suivant de cette sous-couche 44 ou 88 par une sous-couche 46, 86 ou 90. L'un des exemplaires des sous-couches 44 ou 88 peut être situé à l'interface entre cette couche ferromagnétique et la couche antiferromagnétique située juste au-dessus ou juste en-dessous.

Les couches ferromagnétiques ne sont pas nécessairement formées chacune par un seul bloc homogène de matériau ferromagnétique. Par exemple, chaque couche ferromagnétique peut aussi être laminée comme décrit dans la demande de brevet FR 2 892 871 dans le passage page 13, lignes 5 à 9.

Les sous-couches ferromagnétiques 86 et 90 ne sont pas nécessairement réalisées dans le même matériau ferromagnétique. Par exemple, une de ces sous-couches est réalisée en CoFe et l'autre en NiFe.

La couche antiferromagnétique 40 peut elle aussi être formée d'un empilement de plusieurs sous-couches antiferromagnétiques. Par exemple, la couche antiferromagnétique est formée d'une sous-couche en IrMn directement déposée sur une sous-couche en PtMn.

La couche antiferromagnétique 36 déposée sur la couche ferromagnétique du dernier motif de l'empilement peut être omise. Dans ce cas, de préférence, l'épaisseur de la couche 42 de ce dernier motif est réduite par rapport à l'épaisseur de la couche 42 des autres motifs du même empilement.

Il est également possible de combiner, dans un même empilement, des motifs différents. Par exemple, il est possible de construire un empilement en alternant les motifs 34 et 82.

Le matériau ferromagnétique utilisé pour former la sous-couche ferromagnétique 46, 86 ou 90 peut être différent d'un motif à l'autre dans l'empilement. Par exemple, dans l'un des motifs de l'empilement, ce matériau ferromagnétique est le CoFe et dans un autre de ces motifs, ce matériau est le NiFe.

De façon similaire, le matériau antiferromagnétique utilisé pour former la couche 40 d'un motif peut être différent d'un motif à l'autre. Par exemple, dans un motif, ce matériau antiferromagnétique est de l'IrMn et dans un autre motif, il s'agit du PtMn.

La couche d'accroché 52 peut être omise.

L'ordre des couches antiferromagnétique et ferromagnétique à l'intérieur des motifs peut être inversé. Dans ce cas, la couche ferromagnétique est située sous la couche antiferromagnétique.

L'empilement n'a pas nécessairement une forme parallélépipédique. Par exemple, la section de l'empilement parallèlement aux directions X, Y est une ellipse ou un ovale. Dans ces derniers cas, le facteur de forme de l'aimant permanent est défini comme étant le rapport de la longueur sur la largeur du parallélépipède de plus petit volume contenant entièrement l'empilement.

En variante, le facteur de forme de l'empilement n'est pas nécessairement supérieur ou égal à deux. Par exemple, il peut être égal à un.

Dans un mode de réalisation simplifié, la sous-couche 44 ou 88 est uniquement introduite dans une partie seulement des motifs de l'empilement. Ainsi, au moins un motif, et de préférence au moins 40 % ou 50 % ou 80 % des motifs de cet empilement, comportent cette sous-couche 44 ou 88.

## Revendications

1. Aimant permanent comprenant un empilement de N motifs (34 ; 82) empilés immédiatement les uns sur les autres dans une direction d'empilement, où N est un nombre entier supérieur ou égal à deux, chaque motif comportant :
- une couche antiferromagnétique (40) réalisée en matériau antiferromagnétique,
- une couche ferromagnétique (42; 84) réalisée en matériau ferromagnétique, la direction d'aimantation de la couche ferromagnétique étant figée par un couplage d'échange avec la couche antiferromagnétique de ce motif, et la direction d'aimantation de la couche ferromagnétique de N-1 motifs étant également figée par un couplage d'échange avec la couche antiferromagnétique d'un motif immédiatement adjacent dans l'empilement, les directions d'aimantation des différentes couches ferromagnétiques de tous les motifs étant toutes identiques les unes aux autres,
**caractérisé en ce qu'**au moins une couche ferromagnétique (42; 84) comporte :
- une première sous-couche (44 ; 88) réalisée en CoFeB dont l'épaisseur est supérieure à 0,05 nm, et
- une deuxième sous-couche (46 ; 86, 90) réalisée dans un matériau ferromagnétique différent du CoFeB et dont l'épaisseur est supérieure à l'épaisseur de la première sous-couche.

2. Aimant selon la revendication 1, dans lequel la première sous-couche (44 ; 88) est disposée à une distance supérieure ou égale à 5 nm de l'interface entre la couche ferromagnétique (46 ; 90) du motif et la couche antiferromagnétique du motif suivant dans la direction d'empilement, de sorte qu'aucune sous-couche réalisée en CoFeB se trouve à moins de 5 nm de la couche antiferromagnétique du motif suivant.

3. Aimant selon la revendication 2, dans lequel la première sous-couche (44) est directement déposée sur la couche antiferromagnétique du motif.

4. Aimant selon la revendication 2, dans lequel la couche ferromagnétique (84) comporte une troisième sous-couche (86, 90) réalisée dans un matériau ferromagnétique différent du CoFeB et la première sous-couche (88) est située entre ces deuxième et troisième sous-couches (86, 90).

5. Aimant selon l'une quelconque des revendications précédentes, dans lequel la couche ferromagnétique (42 ; 82) de chaque motif comporte un exemplaire de la première sous-couche.

6. Aimant selon l'une quelconque des revendications précédentes, dans lequel l'épaisseur de la première sous-couche (44 ; 88) est inférieure à 5 nm.

7. Aimant selon l'une quelconque des revendications précédentes, dans lequel N est un nombre entier supérieur ou égal à cinq ou dix.

8. Aimant selon l'une quelconque des revendications précédentes, dans lequel la première sous-couche (44 ; 88) comporte entre 10 % et 30% en masse de Bore.

9. Aimant selon l'une quelconque des revendications précédentes, dans lequel l'aimant (20) présente un facteur de forme supérieur ou égal à deux, le facteur de forme étant défini comme le rapport de la longueur sur la largeur du parallélépipède de plus petit volume contenant entièrement l'empilement et la direction d'aimantation de chaque couche ferromagnétique de l'aimant permanent est parallèle à la longueur de ce parallélépipède.

10. Capteur de champ magnétique comportant :
- un substrat (12) s'étendant essentiellement dans un plan appelé « plan du substrat »,
- au moins un aimant (20-22) permanent déplaçable par rapport au substrat en réponse à une variation de l'amplitude ou de la direction d'un champ magnétique à mesurer,
- un transducteur (24-25) fixé sur le substrat, apte à convertir un déplacement de l'aimant permanent en une grandeur électrique représentative de l'amplitude ou de la direction du champ magnétique à mesurer,
**caractérisé en ce que** l'aimant permanent est conforme à l'une quelconque des revendications précédentes.

11. Procédé de fabrication d'un aimant permanent conforme à l'une quelconque des revendications 1 à 9, ce procédé comportant :
a) la formation (70) d'un empilement comportant N motifs empilés immédiatement les uns sur les autres dans une direction d'empilement, chaque motif comportant :
- une couche antiferromagnétique réalisée en matériau antiferromagnétique, et
- une couche ferromagnétique réalisée en matériau ferromagnétique,
b) le chauffage (74) de l'empilement de manière à atteindre une température supérieure à une température de mise en ordre du matériau des couches magnétiques de l'empilement,
c) lorsque la température est supérieure à la température de mise en ordre, l'application (74) d'un premier champ magnétique pour aligner la direction d'aimantation des couches ferromagnétiques sur une direction souhaitée prédéterminée,
d) le refroidissement (78) de l'empilement en présence d'un deuxième champ magnétique inférieur au premier champ magnétique pour faire apparaître un couplage d'échange entre la couche ferromagnétique et la couche antiferromagnétique de chaque motif de l'empilement,
caractérisé à ce que l'étape a) comporte la formation, dans au moins une couche ferromagnétique :
- d'une première sous-couche réalisée en CoFeB dont l'épaisseur est supérieure à 0,05 nm, et
- d'une deuxième sous-couche réalisée dans un matériau ferromagnétique différent du CoFeB, dont l'épaisseur est supérieure à l'épaisseur de la première sous-couche.

## Patentansprüche

1. Dauermagnet, umfassend einen Stapel von N Motiven (34; 82), die direkt übereinander in einer Stapelrichtung gestapelt sind, wobei N eine ganze Zahl größer oder gleich zwei ist, wobei jedes Motiv umfasst:
- eine antiferromagnetische Schicht (40), die aus antiferromagnetischem Material hergestellt ist,
- eine ferromagnetische Schicht (42; 84), die aus ferromagnetischem Material hergestellt ist, wobei die Magnetisierungsrichtung der ferromagnetischen Schicht durch eine Austauschkopplung mit der antiferromagnetischen Schicht dieses Motivs feststehend ist und die Magnetisierungsrichtung der ferromagnetischen Schicht von N-1 Motiven ebenfalls durch eine Austauschkopplung mit der antiferromagnetischen Schicht eines direkt benachbarten Motivs in dem Stapel feststehend ist, wobei die Magnetisierungsrichtungen der unterschiedlichen ferromagnetischen Schichten aller Motive alle zueinander identisch sind,
**dadurch gekennzeichnet, dass** mindestens eine ferromagnetische Schicht (42; 84) Folgendes umfasst:
- eine erste Unterschicht (44; 88), die aus CoFeB hergestellt ist, deren Dicke größer als 0,05 nm ist, und
- eine zweite Unterschicht (46; 86, 90), die aus einem anderen ferromagnetischen Material als CoFeB hergestellt ist und deren Dicke größer als die Dicke der ersten Unterschicht ist.

2. Magnet nach Anspruch 1, bei dem die erste Unterschicht (44; 88) in einem Abstand größer oder gleich 5 nm von der Grenzfläche zwischen der ferromagnetischen Schicht (46; 90) des Motivs und der antiferromagnetischen Schicht des folgenden Motivs in der Stapelrichtung angeordnet ist, so dass sich keine Unterschicht, die aus CoFeB hergestellt ist, weniger als 5 nm von der antiferromagnetischen Schicht des folgenden Motivs befindet.

3. Magnet nach Anspruch 2, bei dem die erste Unterschicht (44) direkt auf der antiferromagnetischen Schicht des Motivs aufgebracht ist.

4. Magnet nach Anspruch 2, bei dem die ferromagnetische Schicht (84) eine dritte Unterschicht (86, 90), die aus einem anderen ferromagnetischen Material als CoFeB hergestellt ist, umfasst und sich die erste Unterschicht (88) zwischen dieser zweiten und dritten Unterschicht (86, 90) befindet.

5. Magnet nach einem der vorhergehenden Ansprüche, bei dem die ferromagnetische Schicht (42; 82) jedes Motivs ein Exemplar der ersten Unterschicht umfasst.

6. Magnet nach einem der vorhergehenden Ansprüche, bei dem die Dicke der ersten Unterschicht (44; 88) kleiner als 5 nm ist.

7. Magnet nach einem der vorhergehenden Ansprüche, bei dem N eine ganze Zahl größer oder gleich fünf oder zehn ist.

8. Magnet nach einem der vorhergehenden Ansprüche, bei dem die erste Unterschicht (44; 88) zwischen 10 und 30 Massen-% Bor umfasst.

9. Magnet nach einem der vorhergehenden Ansprüche, bei dem der Magnet (20) einen Formfaktor größer oder gleich zwei aufweist, wobei der Formfaktor als das Verhältnis der Länge zur Breite des Parallelepipeds mit dem kleinsten Volumen, das den Stapel ganz enthält, definiert ist, und die Magnetisierungsrichtung jeder ferromagnetischen Schicht des Dauermagneten parallel zur Länge dieses Parallelepipeds ist.

10. Magnetfeldsensor, umfassend:
- ein Substrat (12), das sich im Wesentlichen in einer Ebene, "Substratebene" genannt, erstreckt,
- mindestens einen Dauermagneten (20-22), der in Bezug zum Substrat als Antwort auf eine Veränderung der Amplitude oder der Richtung eines zu messenden Magnetfeldes verschiebbar ist,
- einen Wandler (24-25), der auf dem Substrat befestigt und geeignet ist, eine Verschiebung des Dauermagneten in eine elektrische Größe umzuwandeln, die für die Amplitude oder die Richtung des zu messenden Magnetfeldes repräsentativ ist,
**dadurch gekennzeichnet, dass** der Dauermagnet einem der vorhergehenden Ansprüche entspricht.

11. Verfahren zur Herstellung eines Dauermagneten nach einem der Ansprüche 1 bis 9, wobei dieses Verfahren umfasst:
a) die Bildung (70) eines Stapels, umfassend N direkt übereinander in Stapelrichtung gestapelte Motive, wobei jedes Motiv umfasst:
- eine antiferromagnetische Schicht, die aus antiferromagnetischem Material hergestellt ist, und
- eine ferromagnetische Schicht, die aus ferromagnetischem Material hergestellt ist,
b) die Erhitzung (74) des Stapels, um eine Temperatur über einer Ordnungstemperatur des Materials der magnetischen Schichten des Stapels zu erreichen,
c) wenn die Temperatur höher als die Ordnungstemperatur ist, Anlegen (74) eines ersten Magnetfeldes, um die Magnetisierungsrichtung der ferromagnetischen Schichten auf einer vorbestimmten gewünschten Richtung auszurichten,
d) Kühlen (78) des Stapels bei Vorhandensein eines zweiten Magnetfeldes kleiner als das erste Magnetfeld, um eine Austauschkopplung zwischen der ferromagnetischen Schicht und der antiferromagnetischen Schicht jedes Motivs des Stapels auftreten zu lassen,
**dadurch gekennzeichnet, dass** der Schritt a), in mindestenser ferromagnetischen Schicht, die Bildung von Folgendem umfasst:
- einer ersten Unterschicht, die aus CoFeB hergestellt ist, deren Dicke größer als 0,05 nm ist, und
- einer zweiten Unterschicht, die aus einem anderen ferromagnetischen Material als CoFeB hergestellt ist, deren Dicke größer als die Dicke der ersten Unterschicht ist.

## Claims

1. Permanent magnet comprising a stack of N patterns (34; 82) stacked immediately one above the other in a stacking direction, where N is an integer number greater than or equal to two, each pattern comprising:
- an antiferromagnetic layer (40) made of antiferromagnetic material,
- a ferromagnetic layer (42; 84) made of ferromagnetic material, the direction of magnetization of the ferromagnetic layer being fixed by an exchange coupling with the antiferromagnetic layer of this pattern, and the direction of magnetization of the ferromagnetic layer of N-1 patterns also being fixed by an exchange coupling with the antiferromagnetic layer of an immediately adjacent pattern in the stack, the directions of magnetization of the various ferromagnetic layers of all the patterns all being identical to one another,
**characterized in that** at least one ferromagnetic layer (42; 84) comprises:
- a first sub-layer (44; 88) made of CoFeB whose thickness is greater than 0.05 nm, and
- a second sub-layer (46; 86; 90) made of a ferromagnetic material different from CoFeB and whose thickness is greater than the thickness of the first sub-layer.

2. Magnet according to Claim 1, in which the first sub-layer (44; 88) is disposed at a distance of greater than or equal to 5 nm from the interface between the ferromagnetic layer (46; 90) of the pattern and the antiferromagnetic layer of the following pattern in the stacking direction, so that no sub-layer made of CoFeB is situated less than 5 nm from the antiferromagnetic layer of the following pattern.

3. Magnet according to Claim 2, in which the first sub-layer (44) is deposited directly on the antiferromagnetic layer of the pattern.

4. Magnet according to Claim 2, in which the ferromagnetic layer (84) comprises a third sub-layer (86; 90) made of a ferromagnetic material different from CoFeB and the first sub-layer (88) is situated between these second and third sub-layers (86; 90).

5. Magnet according to any one of the preceding claims, in which the ferromagnetic layer (42; 82) of each pattern comprises a copy of the first sub-layer.

6. Magnet according to any one of the preceding claims, in which the thickness of the first sub-layer (44; 88) is less than 5 nm.

7. Magnet according to any one of the preceding claims, in which N is an integer number greater than or equal to five or ten.

8. Magnet according to any one of the preceding claims, in which the first sub-layer (44; 88) comprises between 10 % and 30% by mass of boron.

9. Magnet according to any one of the preceding claims, in which the magnet (20) exhibits an aspect ratio of greater than or equal to two, the aspect ratio being defined as the ratio of the length to the width of the parallelepiped of smallest volume entirely containing the stack and the direction of magnetization of each ferromagnetic layer of the permanent magnet is parallel to the length of this parallelepiped.

10. Magnetic field sensor comprising:
- a substrate (12) extending essentially in a plane called the "plane of the substrate",
- at least one permanent magnet (20; 22) displaceable with respect to the substrate in response to a variation of the amplitude or of the direction of a magnetic field to be measured,
- a transducer (24; 25) fixed on the substrate, able to convert a displacement of the permanent magnet into an electrical quantity representative of the amplitude or of the direction of the magnetic field to be measured,
**characterized in that** the permanent magnet is in accordance with any one of the preceding claims.

11. Process for fabricating a permanent magnet in accordance with any one of Claims 1 to 9, this process comprising:
a) the formation (70) of a stack comprising N patterns stacked immediately one above the other in a stacking direction, each pattern comprising:
- an antiferromagnetic layer made of antiferromagnetic material, and
- a ferromagnetic layer made of ferromagnetic material,
b) the heating (74) of the stack so as to attain a temperature greater than an ordering temperature of the material of the magnetic layers of the stack,
c) when the temperature is greater than the ordering temperature, the application (74) of a first magnetic field so as to align the direction of magnetization of the ferromagnetic layers with a predetermined desired direction,
d) the cooling (78) of the stack in the presence of a second magnetic field less than the first magnetic field so as to reveal an exchange coupling between the ferromagnetic layer and the antiferromagnetic layer of each pattern of the stack, **characterized in that** step a) comprises the formation, in at least one ferromagnetic layer:
- of a first sub-layer made of CoFeB whose thickness is greater than 0.05 nm, and
- of a second sub-layer made of a ferromagnetic material different from CoFeB, whose thickness is greater than the thickness of the first sub-layer.
